# EUROPEAN PATENT SPECIFICATION

(11) **EP 4 020 602 B1**
(45) Date of publication and mention of the grant of the patent: **26.06.2024**
(21) Application number: 21216038.6
(22) Date of filing: 20.12.2021
(51) Int. Cl.: H01L 31/048, H02S 30/00, H02S 20/25

(54) **TILE MODULE**
ZIEGELMODUL
MODULE DE TUILE

(30) Priority: 22.12.2020 CH 16612020
(43) Date of publication of application: 29.06.2022
(73) Proprietor: Climacy SA, 1030 Bussigny (CH)
(72) Inventor: Söderström, Thomas, 1030 Bussigny (CH)
(74) Representative: Linhart, Friedrich Karl Eberhard

(56) References cited:
- US-A1- 2012 080 074
- US-A1- 2014 360 558
- US-B2- 8 528 277
- US-B2- 8 697 981

## Description

### Technical Field

The invention relates to a tile module according to the preamble of claim 1. The invention furthermore relates to a roof system according to claim 9.

### Background Art

In order to cope with the many challenges of climate change, technologies for renewable energy production are becoming more and more important. One possibility to produce electricity in an environmental-friendly manner is to use photovoltaic systems. Typical photovoltaic systems are for example freestanding or mounted on roofs. An alternative to mounting standard photovoltaic (abbreviated: PV) panels on roof tops is the use of so-called PV solar tiles, which are basically designed to replace regular tiles in roofs, or in other words: to be integral parts of roofs, for example of buildings.

Different types of solar tiles are known in the art. For example, small PV solar tiles with surface areas of between 10 and 500 cm² exist. However, such small PV solar tiles are not ideal in terms of cost.

The use of larger PV modules as roof tiles helps to reduce cost and therefore increase the financial efficiency and the attractiveness of the resulting PV systems but many of the existing solutions have frames around the PV modules in order to guarantee the necessary stability and to suppress the so-called lamination bow. The lamination bow is an effect which occurs in PV modules which have a double-glass (also referred to as glass-glass) structure where the silicon part of the PV module is sandwiched between two glass layers. The larger such glass-glass PV modules get, the more pronounced is this bow in the centre of such PV modules. In other words: Large glass-glass PV modules have the disadvantage that the glass layers are not parallel and flat but rather comprise a bow. When such PV modules are used on roofs, the lamination bows in the PV modules can lead to gaps between the different PV modules and such gaps may make it possible for water to enter the roof. In order to avoid this, frames around the double-glass PV modules are sometimes used. Such frames, however, have the disadvantage of increasing cost and of decreasing aesthetics.

The lamination bow is not only a problem in double-glass PV modules but a problem in any kinds of laminated glass structures, for example laminated glass tile modules (i.e., tile modules without photovoltaic properties) or any kinds of solar modules (e.g., PV solar modules or solar thermal collector modules). The lamination bow is a result of an asymmetric heating of the different layers of laminated structures during the lamination process. In short, when producing laminated glass structures, such structures are typically heated only from one side. This leads to differences in thermal extension of the layers and thus to the lamination bow. At least some of the above-mentioned problems of laminated PV modules in principle also apply to all other types of tile modules. In particular, larger tile modules can help to decrease costs but the larger the tile modules get, the more problematic may become the lamination bow.

In patent publication US 8,697,981 B2 it is suggested to pre-bow a PV module during lamination by curving the stack of layers to be laminated in the direction opposite to which the stack bends towards during cooling.

### Problem to be Solved

It is the object of the invention to solve or to at least diminish the above-mentioned disadvantages.

### Solution to the Problem

The problem is solved by a tile module as described in claim 1, wherein the tile module is frameless, wherein the tile module comprises a top glass layer, a bottom glass layer and a retention system for attaching the tile module to a carrying structure, wherein the retention system is configured to exercise a force onto the bottom glass layer once the tile module is attached to the carrying structure, such that a lamination bow in the tile module is essentially suppressed.

In this context, the expression "carrying structure" typically refers to a structure comprising a multitude of battens and/or a multitude of rafters and/or a multitude of rails which are typically used in roof constructions.

In this context, the expression "essentially suppressed" is to be understood such that it includes cases where the formation of a lamination bow is completely suppressed but in some embodiments also cases where a tolerable lamination bow still exists, for example a lamination bow which does not lead to leakage into a roof on which the tile module is mounted.

The inventors have found that by applying a force, typically a retention force, onto the bottom glass layer of such a tile module, the lamination bow can be essentially suppressed. Like this, it becomes possible to use also comparably large tile modules as roof tiles without frames. Like this, cost-effective, aesthetic and reliable roofing solutions can be obtained.

In typical embodiments, the tile module is a solar module, for example a photovoltaic (abbreviated "PV") module or a solar thermal collector module.

In typical embodiments, the retention system comprises at least one, preferably at least two, more preferably at least three, more preferably at least four retention devices. The inventors have found through experiments that such numbers of retention devices in the retention system offer a good trade-off between decrease of the lamination bow and increased stability of the tile module on one hand and system complexity on the other hand. It is, however, also possible to foresee even more retention devices in the retention system.

In typical embodiments, the retention system and/or the retention device(s) comprise(s) a glue. Gluing is a simple and yet effective possibility to connect the tile module, in particular the bottom glass layer, to the carrying structure and to thereby exercise a retention force onto the tile module. In certain embodiments, the glue connects the tile module directly to the carrying structure. In other embodiments, the glue connects the tile module indirectly to the carrying structure, typically in cases where intermediate devices are used.

In typical embodiments, the retention system and/or the retention devices(s) comprise(s) a plate. In typical embodiments, the plate is a metal plate. However, also other materials are possible for the plate, for example plastic. The plate is typically glued to the bottom glass layer of the tile module and is typically screwed to the carrying structure. The use of such a plate compared to the direct gluing of the tile module to the carrying structure is advantageous because it makes it possible to for example remove the tile module from the carrying structure by loosening the screws in the case where a removal of the tile module becomes necessary.

In the invention, the retention system and/or the retention device(s) comprise(s) a hook. The hook is preferably a metal hook but also other materials, for example plastic, ceramics, wood, fiber and/or composite or any combination of these, possibly even on combination with metal, can be used for the hook. The inventors have found that such hooks are particularly advantageous for connecting the tile modules to the carrying structure, for example because the use of hooks allows a flexible positioning and an easy installation. Like the plates, the hooks are typically glued to the bottom glass layer. Compared to the use of plates, the use of hooks has the advantage that the hooks do not necessarily have to be fixed, for example screwed, to the carrying structure because the form of the hooks themselves can retain the tile module onto the carrying structure and thereby suppress the lamination bow.

In typical embodiments, the retention system and/or the retention device(s) comprise(s) a tile module contact area, wherein the tile module contact area typically has a size between 0.5 cm² and 200 cm², preferably between 1 cm² and 100 cm². The expression "tile module contact area" refers to a surface area of the retention system and/or the retention device(s) which is in contact with the tile module, in particular with the bottom glass layer. The inventors have found that such sizes of the tile module contact area are well adapted for the forces which have to be exercised onto the tile modules in order to suppress the lamination bow.

In particular embodiments, the hook has a tile module contact area and a retaining area. The tile module contact area of the hook is that portion of the hook that is in contact with, typically glued to, the bottom glass layer of the tile module. The retaining area of the hook is typically that area of the hook which is in contact with the carrying structure, typically in contact with a part of the carrying structure. In such embodiments, the tile module contact area is preferably larger than the retaining area, preferably at least two times larger, more preferably at least three times larger, more preferably at least four times larger. Such dimensions have the advantage that the contact area between the bottom glass layer and the hook is large enough for ensuring a high-stability glue connection between the bottom glass layer and the hook. On the other hand, the portion of the hook that at least partly embraces the carrying structure can be kept comparably small, because a larger dimension at this point of the hook is not necessary. Like this, a good trade-off between mechanical stability and efficient use of material is being obtained.

In typical embodiments, the retention system is arranged in such a way that the top glass layer and the bottom glass layer are made essentially flat and essentially parallel when the tile module is attached to the carrying structure by means of the retention system. Such an arrangement has the advantage of effectively suppressing the lamination bow.

In typical embodiments, the retention system is arranged at a centre of the bottom glass layer and/or is arranged essentially symmetrically around the centre of the bottom glass layer. The inventors have found that such an arrangement of the retention system is particularly advantageous for suppressing the lamination bow.

In typical embodiments, the tile module has an area of at least 1 m², preferably at least 1.2 m², more preferably at least 1.5 m². In some embodiments, the tile module has an area of 2 m² or more. In some embodiments, the tile module has an area between 5 m² and 10 m².

A typical roof system comprises a multitude of tile modules according to any of the embodiments presented above. In typical embodiments, the roof system is a PV system.

The roof system preferably comprises the carrying structure, wherein the carrying structure typically comprises a multitude of battens and/or a multitude of rafters and/or a multitude of rails. In typical embodiments, the battens and/or rafters are made from wood. In typical embodiments, the rails are made from wood or metal. In typical embodiments, the tile modules are shingled in the roof system.

In typical embodiments, the retention system and/or at least one of the retention devices is/are configured to at least partly extend beyond the rails, in particular downwards, when the tile module is mounted on the rails. In other words: in typical embodiments, a height of the retention system and/or of at least one of the retention devices is typically larger than a height of the rails. This has the advantage that the retention system and/or the retention device(s) can easily reach the carrying structure, for example one or more batten(s) of the carrying structure, when the tile module is mounted on the rails. In typical embodiment, the carrying structure comprises a multitude of rafters, wherein the rafters carry a multitude of battens, wherein the battens are preferably arranged perpendicular to the rafters, wherein the battens carry a multitude of rails, wherein the rails are preferably arranged perpendicular to the battens, wherein the rails carry the tile modules.

### FIGURES

In the following, the invention is described in detail by means of drawings, wherein show:
- Figure 1:: a schematic top view of a PV system mounted on a rail system,
- Figure 2:: a schematic visualisation of a lamination bow,
- Figure 3:: a zoom-in on the lamination bow already shown in Figure 2,
- Figure 4:: a schematic cross-sectional view of one preferred embodiment of a PV module,
- Figure 5:: a cross-sectional view of another preferred embodiment of a PV module,
- Figure 6:: a cross-sectional view of another preferred embodiment of a PV module,
- Figure 7: to 6,: a cross-sectional view through any of the PV modules shown in Figures 4
- Figure 8: Figure 4,: another cross-sectional view of the PV module already shown in
- Figure 9:: another cross-sectional view of a PV module corresponding to the PV module already shown in Figure 5,
- Figure 10:: another cross-sectional view of the PV module already shown in Figure 9, and
- Figure 11:: a schematic rear view of the PV system already shown in Figure 1.

### Description of Preferred Embodiments

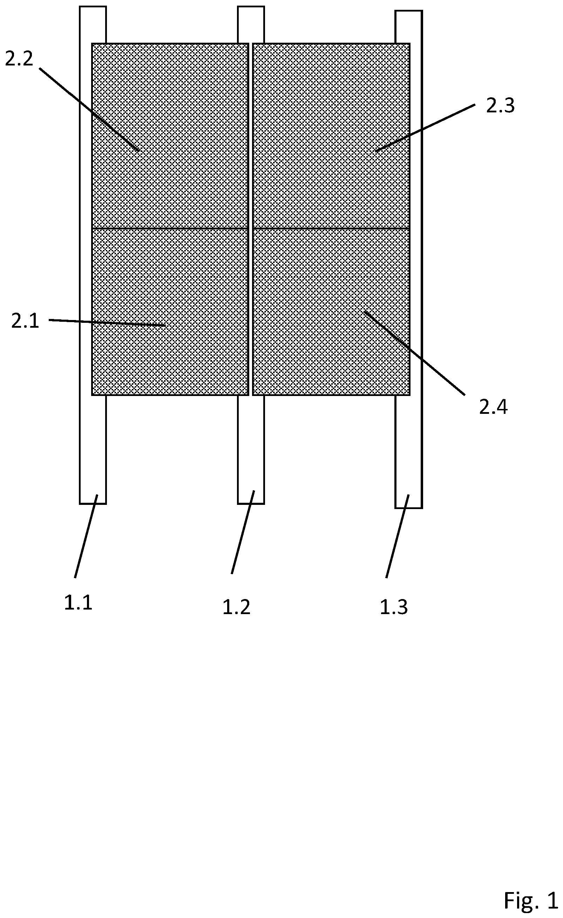

Figure 1 shows a schematic top view of a photovoltaic system mounted on a rail system. The rail system is configured to be mounted on a roof, for example by fixing the rails to a carrying structure of a roof, for example to roof battens. The battens themselves are not shown in Figure 1. The rail system comprises three rails 1.1, 1.2, 1.3. To these rails are attached four PV modules 2.1, 2.2, 2.3, 2.4, which together form the PV system. The PV modules 2.1, 2.2, 2.3, 2.4 are shingled. In particular, PV module 2.2 partly covers PV module 2.1 and PV module 2.3 partly covers PV module 2.4. The PV modules 2.1, 2.2, 2.3, 2.4 in Figure 1 are frameless double-glass PV modules.

As already explained, the larger such PV modules get, the more pronounced is typically the so-called lamination bow.

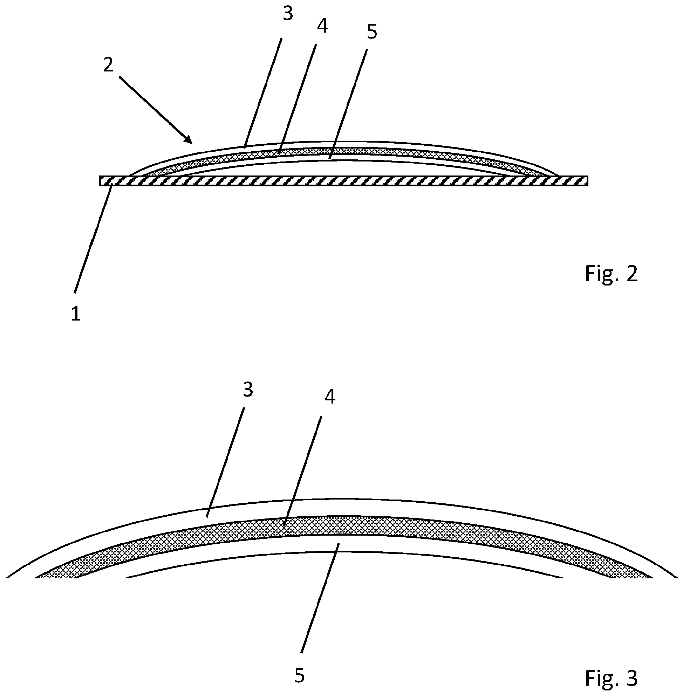

Figure 2 visualises such a lamination bow in a schematic manner. Figure 2 shows a rail 1 to which is fixed a PV module 2. The PV module 2 comprises a top glass layer 3 and a bottom glass layer 5. Sandwiched between the glass layers 3, 5 is a PV module interior 4, which for example comprises a silicon layer which is not separately shown in Figure 2. As can be seen, the top glass layer 3, the PV module interior 4 and the bottom glass layer 5 are not flat but have a lamination bow.

Figure 3 shows a zoom-in on this lamination bow, namely on a top part of this lamination bow. In Figure 3, the fact that the top glass layer 3, the bottom glass layer 5 as well as the PV module interior 4 are not flat anymore due to the lamination bow is clearly visible.

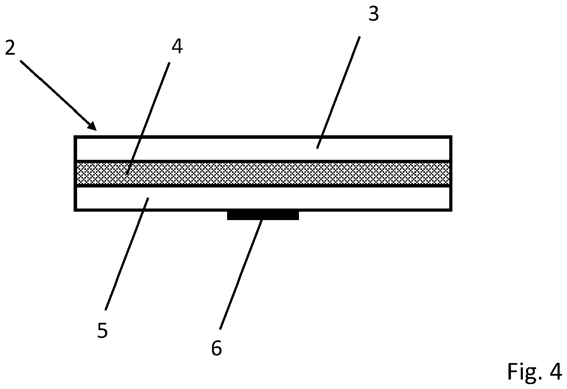

Figure 4 shows a schematic cross-sectional view of one 2. example of a PV module 2. The PV module 2 comprises a top glass layer 3, a bottom glass layer 5 and a PV module interior 4 sandwiched between the glass layers 3, 5. To the bottom glass layer 5 is attached a plate 6. The plate 6 is attached in the centre of the bottom glass layer 5. When the PV module 2 shown in Figure 4 is attached to a rail system which is then attached to a carrying structure of a roof (rail system and carrying structure not shown in Figure 4), then the plate 6 can be attached to the carrying structure of the roof, for example to a roof batten. Like this, the PV module 2 is retained by the carrying structure of the roof through the plate 6. The resulting force, which is thereby exercised on the PV module 2, suppressed the problematic lamination bow visualised in Figures 2 and 3. The plate 6 is typically glued to the bottom glass layer 5 and is attached to the carrying structure by means of screws for example. The screws and the glue are not explicitly shown in Figure 4.

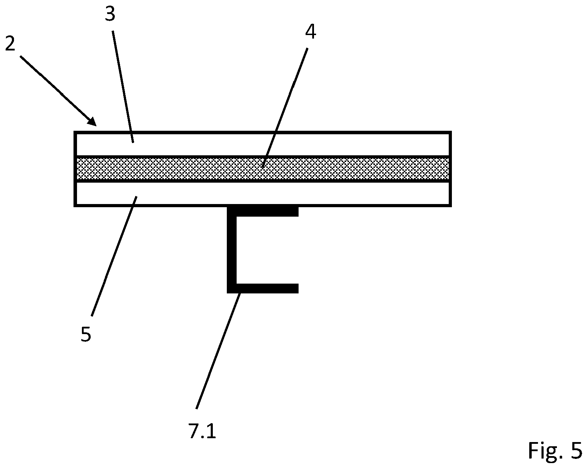

Figure 5 shows a cross-sectional view of an embodiment of a PV module 2. Yet again, this PV module 2 comprises a top glass layer 3, a bottom glass layer 5 and a PV module interior 4. Attached to the bottom glass layer 5, in particular at a centre of the bottom glass layer 5, is a hook 7.1. In other words: The PV module 2 shown in Figure 5 corresponds to the PV module 2 shown in Figure 4 with the sole exception that the plate 6 shown in Figure 4 is replaced by a hook 7.1 in Figure 5. The hook has the form of a U-profile. In typical embodiments, the hook can also have a different form. The hook 7.1 shown in Figure 5 can be used to at least partly embrace for example a batten of a carrying structure of a roof (batten not shown in Figure 5) and thereby retain the PV module 2 to the carrying structure, thus suppressing the lamination bow in the PV module 2.

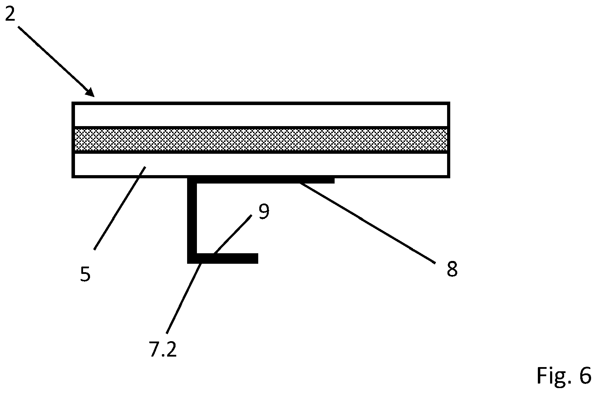

Figure 6 shows another cross-sectional view of a PV module 2 according to a preferred embodiment. The PV module 2 shown in Figure 6 comprises a hook 7.2 which has a slightly different form than the hook 7.1 shown in Figure 5. In particular, the hook 7.2 has a PV module contact area 8 which is larger than a retention area 9. The size of the retention area 9, which is the bottom area of the hook 7.2, which is parallel to the PV module contact area 8, is size-wise adapted to a typical batten of a carrying structure of a roof (batten and carrying structure yet again not shown in Figure 6). The PV module contact area 8 is larger than the retention area 9. This has the advantage that in cases where the hook 7.2 is glued to the PV module 2, the amount of glue between the hook 7.2 and the bottom glass layer 5 is increased, thereby also increasing the force which can be transferred through the glue connection.

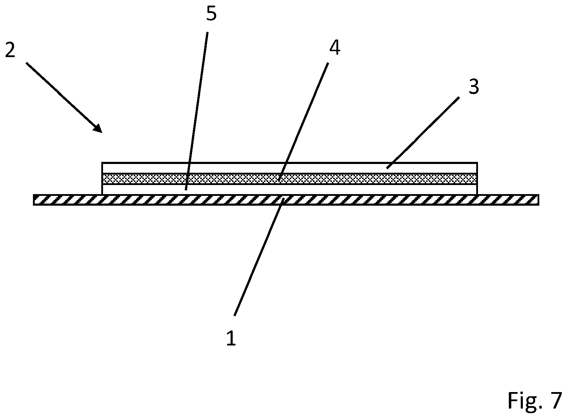

Figure 7 is a cross-sectional view through any of the PV modules 2 shown in Figures 4 to 6. One has to imagine that the PV module 2 is attached to a carrying structure of a roof (not shown in Figure 7) by means of a plate 6 or a hook 7.1, 7.2. Neither the plate 6 nor the hooks 7.1, 7.2 are shown in Figure 7 because the cross-sectional view in Figure 7 does not run through the retention devices but rather runs through the rail 1. However, because the PV module 2 is fixed to the carrying structure by means of a retention device such as the plate 6 or the hooks 7.1, 7.2, the top glass layer 3, the bottom glass layer 5, as well as the PV module interior 4 are flat and parallel on the rail 1 and the lamination bow shown in Figures 2 and 3 is not present.

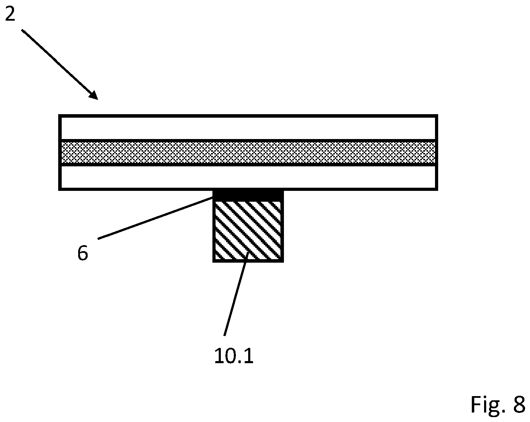

Figure 8 now shows another schematic cross-sectional view of the PV module 2 already shown in Figure 4. However, this time, the plate 6 attached to the PV module 2 is also attached to a batten 10.1 of a carrying structure of a roof on which the PV module 2 (and other PV modules not explicitly shown in Figure 8) are mounted. The fact that the PV module 2 is attached to the carrying structure through the plate 6 has the effect that the lamination bow in the PV module 2 is suppressed.

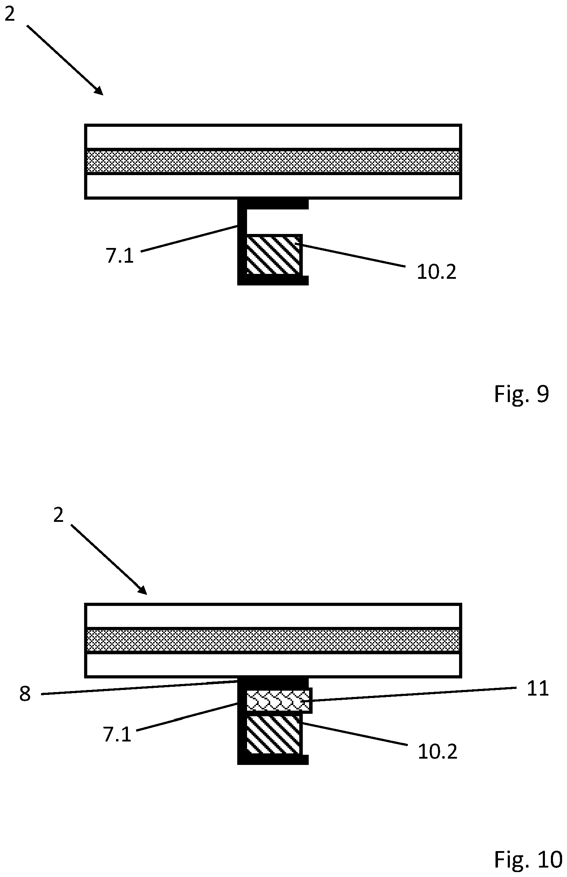

Figure 9 is a cross-sectional view of a PV module 2 corresponding to the PV module 2 already shown in Figure 5. However, in Figure 9, the PV module 2 is attached by means of the hook 7.1 to a batten 10.2 of a carrying structure of a roof. One can see that the batten 10.2 has been inserted into the hook 7.1 and the hook 7.1 partly embraces the batten 10.2. Like this, the PV module 2 is retained by the batten 10.2 and the hook 7.1 and the lamination bow is suppressed.

Figure 10 is another cross-sectional view of the PV module 2 already shown in Figure 9. The difference compared to the embodiment shown in Figure 9 is that in Figure 10 the tile module comprises an intermediate element 11, which is inserted into a space between the batten 10.2 and the PV module contact area 8. By means of such an intermediate element 11, a relative movement between the batten 10.2 and the hook 7.1 can be avoided. This helps to increase the stability of the overall system. The intermediate element 11 can in some embodiments be made of wood, plastic, cloth or any other type of flexible or semi-rigid material.

However, such an intermediate element is not necessarily needed. For example, a relative movement between the hook 7.1 and the batten 10.2 can also be avoided by attaching the batten 10.2 to the hook 7.1, for example by means of screws.

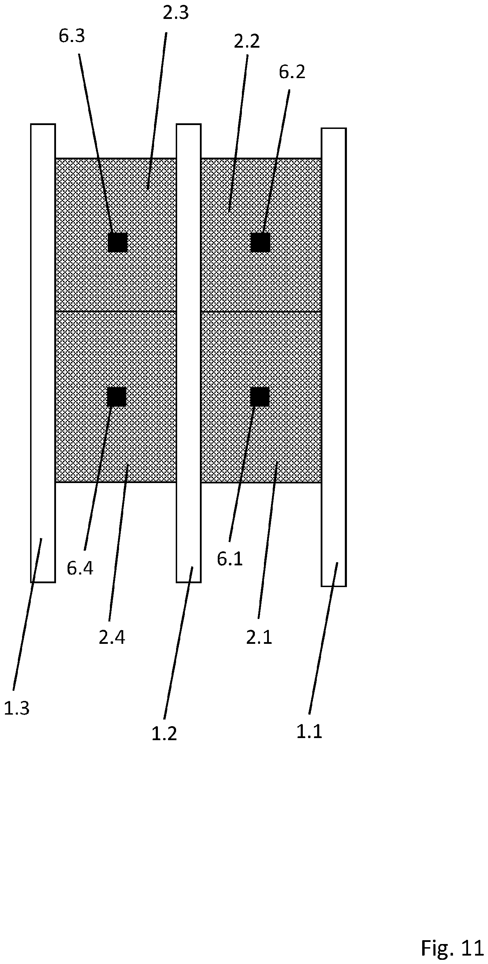

Figure 11 now shows a schematic rear view of the PV system already shown in Figure 1. The PV system yet again comprises the four PV modules 2.1, 2.2, 2.3, 2.4 which are mounted on the rails 1.1, 1.2, 1.3. To each PV module 2.1, 2.2, 2.3, 2.4 is attached a respective plate 6.1, 6.2, 6.3, 6.4 as retention system. By means of these retention systems, each PV module 2.1, 2.2, 2.3, 2.4 can be attached to a carrying structure, for example a batten of a roof (not shown in Figure 11). Like this, the lamination bows in the PV modules 2.1, 2.2, 2.3, 2.4 can be suppressed.

Even though the preferred embodiments exclusively show PV modules as particular examples of tile modules, the preferred embodiments outlined above can also be adapted to tile modules in general. In some embodiments, the PV modules shown in Figures 1 to 11 are replaced by other types of tile modules, for example laminated double glass tiles or solar thermal tiles.

The invention is not limited to the preferred embodiments described here. The scope of protection is defined by the claims.

### List of reference signs

- 1, 1.1, 1.2, 1.3: Rail
- 2, 2.1, 2.2, 2.3, 2.4: PV modules
- 3: Top glass layer
- 4: PV module interior
- 5: Bottom glass layer
- 6, 6.1, 6.2, 6.3, 6.4: Plate
- 7.1,7.2: Hooks
- 8: PV module contact area (of hook)
- 9: Retaining area (of hook)
- 10.1, 10.2: Batten
- 11: Intermediate element

## Claims

1. Tile module (2, 2.1, 2.2, 2.3, 2.4), wherein the tile module (2, 2.1, 2.2, 2.3, 2.4) is frameless, wherein the tile module (2, 2.1, 2.2, 2.3, 2.4) comprises:
- a top glass layer (3),
- a bottom glass layer (5), and
- a retention system (6, 6.1, 6.2, 6.3, 6.4, 7.1, 7.2) for attaching the tile module (2, 2.1, 2.2, 2.3, 2.4) to a carrying structure,
**characterized in that**
the retention system (6, 6.1, 6.2, 6.3, 6.4, 7.1, 7.2) is configured to exercise a force onto the bottom glass layer (5) once the tile module (2, 2.1, 2.2, 2.3, 2.4) is attached to the carrying structure (10.1, 10.2), such that a lamination bow in the tile module (2, 2.1, 2.2, 2.3, 2.4) is essentially suppressed, wherein the retention system (6, 6.1, 6.2, 6.3, 6.4, 7.1, 7.2) comprises a hook (7.1, 7.2).

2. Tile module (2, 2.1, 2.2, 2.3, 2.4) according to any of the preceding claims, **characterized in that** the retention system (6, 6.1, 6.2, 6.3, 6.4, 7.1, 7.2) comprises at least one, preferably at least two, more preferably at least three, more preferably at least four retention devices (6, 6.1, 6.2, 6.3, 6.4, 7.1, 7.2).

3. Tile module (2, 2.1, 2.2, 2.3, 2.4) according to any of the previous claims, **characterized in that** the retention system (6, 6.1, 6.2, 6.3, 6.4, 7.1, 7.2) and/or the retention device(s) (6, 6.1, 6.2, 6.3, 6.4, 7.1, 7.2) comprise(s) a glue.

4. Tile module (2, 2.1, 2.2, 2.3, 2.4) according to any of the previous claims, **characterized in that** the retention system (6, 6.1, 6.2, 6.3, 6.4, 7.1, 7.2) and/or the retention device(s) (6, 6.1, 6.2, 6.3, 6.4, 7.1, 7.2) comprise(s) a plate (6, 6.1, 6.2, 6.3, 6.4).

5. Tile module (2, 2.1, 2.2, 2.3, 2.4) according to any of the previous claims, **characterized in that** the retention system (6, 6.1, 6.2, 6.3, 6.4, 7.1, 7.2) and/or the retention device(s) (6, 6.1, 6.2, 6.3, 6.4, 7.1, 7.2) comprise(s) a tile module contact area (8), wherein the tile module contact area (8) typically has a size between 0.5 cm² and 200 cm², preferably between 1 cm² and 100 cm².

6. Tile module (2, 2.1, 2.2, 2.3, 2.4) according to any of the previous claims, **characterized in that** the retention system (6, 6.1, 6.2, 6.3, 6.4, 7.1, 7.2) is arranged in such a way that the top glass layer (3) and the bottom glass layer (5) are made essentially flat and essentially parallel when the tile module (2, 2.1, 2.2, 2.3, 2.4) is attached to the carrying structure (10.1, 10.2) by means of the retention system (6, 6.1, 6.2, 6.3, 6.4, 7.1, 7.2).

7. Tile module (2, 2.1, 2.2, 2.3, 2.4) according to any of the previous claims, **characterized in that** the retention system (6, 6.1, 6.2, 6.3, 6.4, 7.1, 7.2) is arranged at a centre of the bottom glass layer (5) and/or is arranged essentially symmetrically around the centre of the bottom glass layer (5).

8. Tile module (2, 2.1, 2.2, 2.3, 2.4) according to any of the previous claims, **characterized in that** the tile module (2, 2.1, 2.2, 2.3, 2.4) has an area of at least 1 m², preferably at least 1.2 m², more preferably at least 1.5 m².

9. Roof system comprising a multitude of tile modules (2, 2.1, 2.2, 2.3, 2.4) according to any of the claims 1 to 8.

## Patentansprüche

1. Ziegelmodul (2, 2.1, 2.2, 2.3, 2.4), wobei das Ziegelmodul (2, 2.1, 2.2, 2.3, 2.4) rahmenlos ist, wobei das Ziegelmodul (2, 2.1, 2.2, 2.3, 2.4) umfasst:
- eine obere Glasschicht (3),
- eine untere Glasschicht (5), und
- ein Haltesystem (6, 6.1, 6.2, 6.3, 6.4, 7.1, 7.2) zum Befestigen des Ziegelmoduls (2, 2.1, 2.2, 2.3, 2.4) an einer Tragstruktur,
**dadurch gekennzeichnet, dass**
das Haltesystem (6, 6.1, 6.2, 6.3, 6.4, 7.1, 7.2) konfiguriert ist, um eine Kraft auf die untere Glasschicht (5) auszuüben, wenn das Ziegelmodul (2, 2.1, 2.2, 2.3, 2.4) an der Tragstruktur (10.1, 10.2) befestigt ist, sodass eine Laminierungswölbung in dem Ziegelmodul (2, 2.1, 2.2, 2.3, 2.4) im Wesentlichen unterdrückt wird, wobei das Haltesystem (6, 6.1, 6.2, 6.3, 6.4, 7.1, 7.2) einen Haken (7.1, 7.2) umfasst.

2. Ziegelmodul (2, 2.1, 2.2, 2.3, 2.4) nach einem der vorhergehenden Ansprüche, **dadurch gekennzeichnet, dass** das Haltesystem (6, 6.1, 6.2, 6.3, 6.4, 7.1, 7.2) zumindest eine, bevorzugt zumindest zwei, bevorzugter zumindest drei, bevorzugter zumindest vier Haltevorrichtungen (6, 6.1, 6.2, 6.3, 6.4, 7.1, 7.2) umfasst.

3. Ziegelmodul (2, 2.1, 2.2, 2.3, 2.4) nach einem der vorhergehenden Ansprüche, **dadurch gekennzeichnet, dass** das Haltesystem (6, 6.1, 6.2, 6.3, 6.4, 7.1, 7.2) und/oder die Haltevorrichtungen(en) (6, 6.1, 6.2, 6.3, 6.4, 7.1, 7.2) einen Klebstoff umfasst/umfassen.

4. Ziegelmodul (2, 2.1, 2.2, 2.3, 2.4) nach einem der vorhergehenden Ansprüche, **dadurch gekennzeichnet, dass** das Haltesystem (6, 6.1, 6.2, 6.3, 6.4, 7.1, 7.2) und/oder die Haltevorrichtung(en) (6, 6.1, 6.2, 6.3, 6.4, 7.1, 7.2) eine Platte (6, 6.1, 6.2, 6.3, 6.4) umfasst/umfassen.

5. Ziegelmodul (2, 2.1, 2.2, 2.3, 2.4) nach einem der vorhergehenden Ansprüche, **dadurch gekennzeichnet, dass** das Haltesystem (6, 6.1, 6.2, 6.3, 6.4, 7.1, 7.2) und/oder die Haltevorrichtung(en) (6, 6.1, 6.2, 6.3, 6.4, 7.1, 7.2) eine Ziegelmodul-Kontaktfläche (8) umfasst/umfassen, wobei die Ziegelmodul-Kontaktfläche (8) typischerweise eine Grösse zwischen 0.5 cm² und 200 cm², bevorzugt zwischen 1 cm² 100 cm² hat.

6. Ziegelmodul (2, 2.1, 2.2, 2.3, 2.4) nach einem der vorhergehenden Ansprüche, **dadurch gekennzeichnet, dass** das Haltesystem (6, 6.1, 6.2, 6.3, 6.4, 7.1, 7.2) derart eingerichtet ist, dass die obere Glasschicht (3) und die untere Glasschicht (5) im Wesentlichen flach und im Wesentlichen parallel gemacht werden, wenn das Ziegelmodul (2, 2.1, 2.2, 2.3, 2.4) mittels des Haltesystems (6, 6.1, 6.2, 6.3, 6.4, 7.1, 7.2) an der Tragstruktur (10.1, 10.2) befestigt ist.

7. Ziegelmodul (2, 2.1, 2.2, 2.3, 2.4) nach einem der vorhergehenden Ansprüche, **dadurch gekennzeichnet, dass** das Haltesystem (6, 6.1, 6.2, 6.3, 6.4, 7.1, 7.2) in einer Mitte der unteren Glasschicht (5) angeordnet ist und oder im Wesentlichen symmetrisch um die Mitte der unteren Glasschicht (5) herum angeordnet ist.

8. Ziegelmodul (2, 2.1, 2.2, 2.3, 2.4) nach einem der vorhergehenden Ansprüche, **dadurch gekennzeichnet, dass** das Ziegelmodul (2, 2.1, 2.2, 2.3, 2.4) eine Fläche von mindestens 1 m², bevorzugt mindestens 1.2 m², bevorzugter mindestens 1.5 m² hat.

9. Dachsystem umfassend eine Mehrzahl an Ziegelmodulen (2, 2.1, 2.2, 2.3, 2.4) nach einem der Ansprüche 1 bis 8.

## Revendications

1. Module de tuile (2, 2.1, 2.2, 2.3, 2.4), dans lequel le module de tuile (2, 2.1, 2.2, 2.3, 2.4) est sans cadre, dans lequel le module de tuile (2, 2.1, 2.2, 2.3, 2.4) comprend :
- une couche supérieure de verre (3),
- une couche inférieure de verre (5), et
- un système de rétention (6, 6.1, 6.2, 6.3, 6.4, 7.1, 7.2) pour attacher le module de tuile (2, 2.1, 2.2, 2.3, 2.4) à une structure porteuse,
**caractérisé en ce que**
le système de rétention (6, 6.1, 6.2, 6.3, 6.4, 7.1, 7.2) est configuré pour exercer une force sur la couche de verre inférieure (5) une fois que le module de tuile (2, 2.1, 2.2, 2.3, 2.4) est attaché à la structure porteuse (10.1, 10.2), de telle sorte qu'une courbure du laminat dans le module de tuile (2, 2.1, 2.2, 2.3, 2.4) soit essentiellement supprimé, dans lequel le système de rétention (6, 6.1, 6.2, 6.3, 6.4, 7.1, 7.2) comprend un crochet (7.1, 7.2).

2. Module de tuile (2, 2.1, 2.2, 2.3, 2.4) selon l'une quelconque des revendications précédentes, **caractérisé en ce que** le système de rétention (6, 6.1, 6.2, 6.3, 6.4, 7.1, 7.2) comprend au moins un, préférablement au moins deux, plus préférablement au moins trois, plus préférablement au moins quatre dispositifs de rétention (6, 6.1, 6.2, 6.3, 6.4, 7.1, 7.2).

3. Module de tuile (2, 2.1, 2.2, 2.3, 2.4) selon l'une quelconque des revendications précédentes, **caractérisé en ce que** le système de rétention (6, 6.1, 6.2, 6.3, 6.4, 7.1, 7.2) et/ou le(s) dispositif(s) de rétention (6, 6.1, 6.2, 6.3, 6.4, 7.1, 7.2) comprend/comprennent une colle.

4. Module de tuile (2, 2.1, 2.2, 2.3, 2.4) selon l'une quelconque des revendications précédentes, **caractérisé en ce que** le système de rétention (6, 6.1, 6.2, 6.3, 6.4, 7.1, 7.2) et/ou le(s) dispositif(s) de rétention (6, 6.1, 6.2, 6.3, 6.4, 7.1, 7.2) comprend/comprennent une plaque (6, 6.1, 6.2, 6.3, 6.4).

5. Module de tuile (2, 2.1, 2.2, 2.3, 2.4) selon l'une quelconque des revendications précédentes, **caractérisé en ce que** le système de rétention (6, 6.1, 6.2, 6.3, 6.4, 7.1, 7.2) et/ou le(s) dispositif(s) de rétention (6, 6.1, 6.2, 6.3, 6.4, 7.1, 7.2) comprend/comprennent une zone de contact (8) du module de tuile, où la zone de contact (8) du module de tuile a typiquement une taille comprise entre 0.5 cm² et 200 cm², de préférence entre 1 cm² et 100 cm².

6. Module de tuile (2, 2.1, 2.2, 2.3, 2.4) selon l'une quelconque des revendications précédentes, **caractérisé en ce que** le système de rétention (6, 6.1, 6.2, 6.3, 6.4, 7.1, 7.2) est arrangé de telle manière que la couche de verre supérieure (3) et la couche de verre inférieure (5) sont faites essentiellement plates et essentiellement parallèles lorsque le module de tuile (2, 2.1, 2.2, 2.3, 2.4) est attaché à la structure porteuse (10.1, 10.2) au moyen du système de rétention (6, 6.1, 6.2, 6.3, 6.4, 7.1, 7.2).

7. Module de tuile (2, 2.1, 2.2, 2.3, 2.4) selon l'une quelconque des revendications précédentes, **caractérisé en ce que** le système de rétention (6, 6.1, 6.2, 6.3, 6.4, 7.1, 7.2) est arrangé à un centre de la couche de verre inférieure (5) et/ou est arrangé essentiellement symétriquement autour du centre de la couche de verre inférieure (5).

8. Module de tuile (2, 2.1, 2.2, 2.3, 2.4) selon l'une quelconque des revendications précédentes, **caractérisé en ce que** le module de tuile (2, 2.1, 2.2, 2.3, 2.4) a une superficie d'au moins 1 m², préférablement d'au moins 1.2 m², plus préférablement d'au moins 1.5 m².

9. Système de toiture comprenant une multitude de modules de tuiles (2, 2.1, 2.2, 2.3, 2.4) selon l'une quelconque des revendications 1 à 8.
